# EUROPEAN PATENT APPLICATION

(11) **EP 4 654 194 A1**
(43) Date of publication of application: **26.11.2025**
(21) Application number: 24744550.5
(22) Date of filing: 11.01.2024
(51) Int. Cl.: G11C 11/16

(54) **STORAGE DEVICE, ELECTRONIC APPARATUS, AND METHOD FOR CONTROLLING STORAGE DEVICE**

(30) Priority: 20.01.2023 JP 2023007447
(71) Applicant: Sony Semiconductor Solutions Corporation, Atsugi-shi, Kanagawa 243-0014 (JP)
(72) Inventor: SAKAI, Lui, Atsugi-shi, Kanagawa 243-0014 (JP); HIGO, Yutaka, Atsugi-shi, Kanagawa 243-0014 (JP); HOSOMI, Masanori, Atsugi-shi, Kanagawa 243-0014 (JP); HIRAGA, Keizo, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/000332
(87) International publication number: WO 2024/154627

(57) **Abstract**

A storage device according to an aspect of the present disclosure includes: a magnetoresistive element whose magnetization direction is variable between a first state and a second state; a selection element connected to the magnetoresistive element; and a write unit that switches and supplies, to the magnetoresistive element, a first current for bringing the magnetization direction of the magnetoresistive element into the first state and a second current for bringing the magnetization direction of the magnetoresistive element into the second state.

## Description

### Field

The present disclosure relates to a storage device, an electronic apparatus, and a storage device control method.

### Background

Since a magnetoresistive random access memory (MRAM) using a magnetoresistive element as a storage element maintains a state with a magnetization state of a ferromagnetic material, the MRAM has non-volatility in which recorded data is maintained even when a power supply is turned off. A basic structure of the magnetoresistive element is a sandwich structure in which a nonmagnetic thin film of an insulator is sandwiched between two magnetic layers made of magnetic thin films. This structure is referred to as a magnetic tunnel junction (MTJ). Since the film thickness of the nonmagnetic thin film is as very thin as about several nm, a tunnel current flows when a voltage is applied across the element. The magnitude of the tunnel current depends on the relative angle of magnetization of the two magnetic layers. This is called a tunnel magnetoresistance (TMR) effect.

In the MRAM, the magnetization of one magnetic layer (magnetization fixed layer) of the two magnetic layers is fixed, and the magnetization of the other magnetic layer (recording layer) is controlled by an external field. For example, a state in which the magnetization of the magnetization fixed layer and the magnetization of the recording layer (storage layer) are parallel to each other is referred to as a state 0, and a state in which the magnetization of the magnetization fixed layer and the magnetization of the recording layer (storage layer) are antiparallel to each other is referred to as a state 1. In this way, the state is stored in a nonvolatile manner by rewriting the parallel/antiparallel states of magnetization. Examples of the external field used for the magnetization direction control include a current magnetic field generated by current energization to external wiring, a method in which current energization is directly performed on the MTJ to utilize a spin transfer torque (STT) effect, and a method in which magnetic anisotropy control by voltage (Voltage Controlled Magnetic Anisotropy (VCMA)) is utilized. The TMR effect is used to read the state.

A currently mainstream MRAM is an STT-MRAM that can be made finer than using a current magnetic field and can reduce power consumption. On the other hand, a voltage controlled (VC) MRAM using VCMA attracts attention because the VC-MRAM can perform writing at a high speed and operate with lower power consumption. The voltage writing method using VCMA disclosed in Patent Literature 1 realizes bidirectional writing by applying a constant pulse voltage in a unipolar manner (applying a voltage only in one direction). In addition, in Patent Literature 1, initial reading is executed as a first procedure after the start of writing. That is, the initial reading is first performed, and thereafter, it is checked whether or not the read state matches an expected state, and writing (programming) to rewrite the state is executed only when these states do not match.

### Citation List

### Patent Literature

Patent Literature 1: JP 2018-092696 A

### Summary

### Technical Problem

However, since the initial reading is performed as the first procedure after the start of writing in the write processing as described above, a write processing time from the start of writing to the end of writing becomes long. This impairs the characteristics of the high-speed VC-MRAM.

Therefore, the present disclosure provides a storage device, an electronic apparatus, and a storage device control method capable of shortening the write processing time.

### Solution to Problem

A storage device according to an aspect of the present disclosure includes: a magnetoresistive element whose magnetization direction is variable between a first state and a second state; a selection element connected to the magnetoresistive element; and a write unit that switches and supplies, to the magnetoresistive element, a first current for bringing the magnetization direction of the magnetoresistive element into the first state and a second current for bringing the magnetization direction of the magnetoresistive element into the second state.

An electronic apparatus according to an aspect of the present disclosure includes a storage device that stores data, wherein the storage device includes a magnetoresistive element whose magnetization direction is variable between a first state and a second state, a selection element connected to the magnetoresistive element, and a write unit that switches and supplies, to the magnetoresistive element, a first current for bringing the magnetization direction of the magnetoresistive element into the first state and a second current for bringing the magnetization direction of the magnetoresistive element into the second state.

A storage device control method according to an aspect of the present disclosure includes switching and supplying, to a magnetoresistive element whose magnetization direction is variable between a first state and a second state, a first current for bringing the magnetization direction of the magnetoresistive element into the first state and a second current for bringing the magnetization direction of the magnetoresistive element into the second state.

### Brief Description of Drawings

FIG. 1 is a diagram illustrating a configuration example of a memory system according to a first embodiment.
FIG. 2 is a diagram illustrating a configuration example of a memory cell according to the first embodiment.
FIG. 3 is a diagram illustrating a configuration example of a constant current generation circuit according to the first embodiment.
FIG. 4 is a diagram illustrating a configuration example of a first voltage generation circuit according to the first embodiment.
FIG. 5 is a diagram illustrating a configuration example of a second voltage generation circuit according to the first embodiment.
FIG. 6 is a flowchart illustrating a flow of write processing according to the first embodiment.
FIG. 7 is a diagram illustrating a timing chart of write processing with a low constant current according to the first embodiment.
FIG. 8 is a diagram illustrating a timing chart of write processing with a high constant current according to the first embodiment.
FIG. 9 is a diagram illustrating behavior of a magnetization vector when the low constant current is caused to flow through a magnetoresistive element according to the first embodiment.
FIG. 10 is a diagram illustrating behavior of a magnetization vector when the high constant current is caused to flow through the magnetoresistive element according to the first embodiment.
FIG. 11 is a flowchart illustrating a flow of write processing according to a second embodiment.
FIG. 12 is a diagram illustrating a timing chart of write processing with a low constant current according to the second embodiment.
FIG. 13 is a diagram illustrating a timing chart of write processing with a high constant current according to the second embodiment.
FIG. 14 is a flowchart illustrating a flow of write processing according to Modification 1 of the second embodiment.
FIG. 15 is a flowchart illustrating a flow of write processing according to Modification 2 of the second embodiment.
FIG. 16 is a diagram illustrating a configuration example of a first voltage generation circuit according to a third embodiment.
FIG. 17 is a diagram illustrating a timing chart of write processing with a low constant current according to the third embodiment.
FIG. 18 is a diagram illustrating a pulse current according to the third embodiment.
FIG. 19 is a diagram illustrating a memory cell and a constant current generation circuit according to the third embodiment.
FIG. 20 is a diagram illustrating a relationship between a pulse width and a write error rate for each pulse current (constant current value) according to the third embodiment.
FIG. 21 is a diagram illustrating a relationship between a pulse width and a write error rate for each pulse current (constant current value and switching current value) according to the third embodiment.
FIG. 22 is a flowchart illustrating a flow of write processing according to a fourth embodiment.
FIG. 23 is a diagram illustrating a timing chart of write processing with a low constant current according to the fourth embodiment.
FIG. 24 is a diagram illustrating an example of a schematic configuration of an imaging device.
FIG. 25 is a diagram illustrating an example of a schematic configuration of a distance measuring device.
FIG. 26 is a diagram illustrating an example of an appearance of a game apparatus.
FIG. 27 is a diagram illustrating an example of a schematic configuration of the game apparatus.

### Description of Embodiments

Hereinafter, embodiments of the present disclosure will be described in detail with reference to the drawings. The embodiments also include examples and modifications. Note that a device, an apparatus, a method, and the like according to the present disclosure are not limited by the embodiments. In addition, in the following embodiments, basically the same parts are denoted by the same reference numerals, and redundant description is omitted.

The following one or plurality of embodiments can each be implemented independently. On the other hand, the following plurality of embodiments may be implemented by appropriately combining at least some of the embodiments with at least some of other embodiments. The plurality of embodiments may include novel features different from each other. Therefore, the embodiments can contribute to solving different objects or problems, and can exhibit different effects. Note that the effects in the embodiments are merely examples and are not limited, and other effects may be provided.

In addition, the drawings referred to in the following description are drawings for promoting the description and understanding of an embodiment of the present disclosure, and shapes, dimensions, ratios, and the like illustrated in the drawings may be different from actual ones for the sake of clarity. Furthermore, the elements and the like illustrated in the drawings can be appropriately modified in design in consideration of the following description and known techniques. In addition, in the following description, the vertical direction of a stacked structure of the element and the like corresponds to a relative direction in a case where a surface on a substrate on which the element is provided is upward, and may be different from the vertical direction according to the actual gravitational acceleration.

Note that in describing a magnetization direction (magnetic moment) and magnetic anisotropy, terms such as a "perpendicular direction" (a direction perpendicular to a film surface or a stacking direction of the stacked structure) and an "in-plane direction" (a direction parallel to the film surface or a direction perpendicular to the stacking direction of the stacked structure) may be used for convenience. However, these terms do not necessarily mean the exact direction of magnetization. For example, wording such as "the magnetization direction is the perpendicular direction" or "having perpendicular magnetic anisotropy" means that magnetization in the perpendicular direction is superior to magnetization in the in-plane direction. Similarly, for example, wording such as "the magnetization direction is the in-plane direction" or "having in-plane magnetic anisotropy" means that magnetization in the in-plane direction is superior to magnetization in the perpendicular direction.

The present disclosure will be described according to the following order of items.
1. First Embodiment
   1-1. Configuration Example of Storage Device
   1-2. Configuration Example of Memory Cell
   1-3. Configuration Example of Constant Current Generation Circuit
   1-4. Processing Example of Write Processing
   1-5. Timing Chart of Write Processing
   1-6. Behavior of Magnetization Vector by Constant Current
2. Second Embodiment
   2-1. Processing Example of Write Processing
   2-2. Timing Chart of Write Processing
   2-3. Modification 1 of Write Processing
   2-4. Modification 2 of Write Processing
3. Third Embodiment
   3-1. Configuration Example of First Voltage Generation Circuit
   3-2. Timing Chart of Write Processing
4. Fourth Embodiment
   4-1. Processing Example of Write Processing
   4-2. Timing Chart of Write Processing
5. Operations and Effects according to Each Embodiment
6. Other Embodiments
7. Configuration Example of Electronic Apparatus
   7-1. Imaging Device
   7-2. Distance Measuring Device
   7-3. Game Apparatus
8. Appendix

### <1. First Embodiment>

### <1-1. Configuration Example of Storage Device>

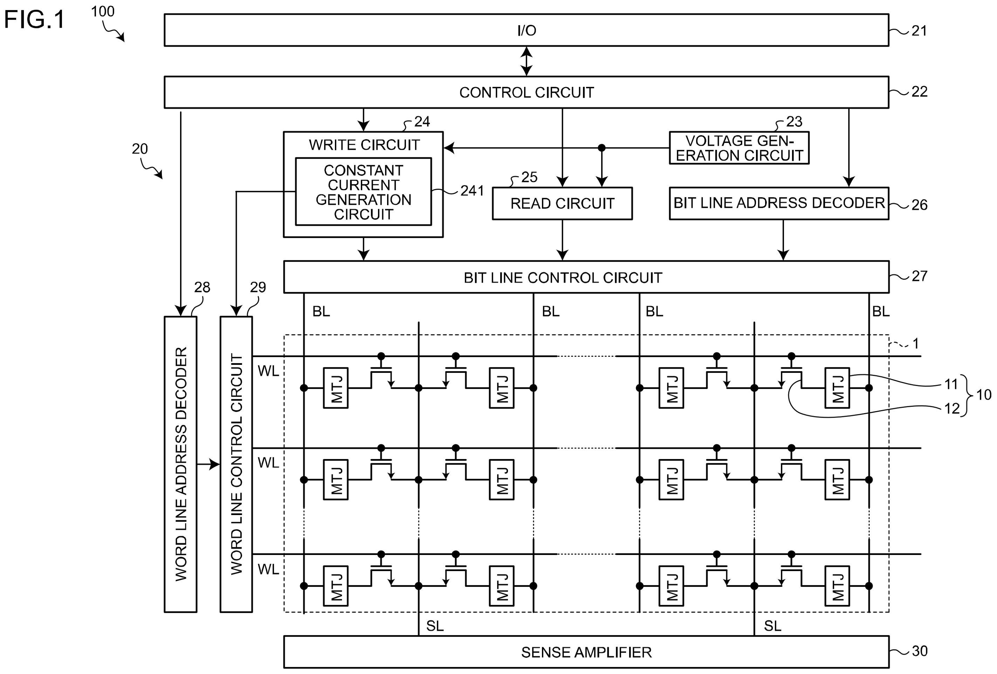

A configuration example of a storage device 100 according to the present embodiment will be described with reference to FIG. 1. FIG. 1 is a diagram illustrating the configuration example of the storage device 100 according to the present embodiment.

As illustrated in FIG. 1, the storage device 100 according to the present embodiment includes a memory cell array 1. The storage device 100 is an example of a storage device that holds data according to a magnetization direction of a magnetic material.

The memory cell array 1 includes a plurality of memory cells 10 arranged two-dimensionally. Each of the memory cells 10 is connected to a bit line BL, a source line SL, and a word line WL. Each of the word lines WL is wired so as to extend in a row direction, and each of the bit lines BL and each of the source lines SL are wired so as to extend in a column direction. Note that the bit line BL, the source line SL, and the word line WL each function as a control line.

Each of the memory cells 10 includes a magnetoresistive element 11 and a selection element 12. As the magnetoresistive element 11, for example, a magnetoresistive element such as an MTJ can be used. The selection element 12 is an element that is connected to one end of the magnetoresistive element 11 and controls application of a voltage, a current, or the like to the magnetoresistive element 11. As the selection element 12, for example, various transistors can be used.

The storage device 100 includes various peripheral circuits 20 in addition to the memory cell array 1. In the example of FIG. 1, an I/O 21, a control circuit 22, a voltage generation circuit 23, a write circuit 24, a read circuit 25, a bit line address decoder 26, a bit line control circuit 27, a word line address decoder 28, a word line control circuit 29, and a sense amplifier 30 are illustrated as the peripheral circuits 20. The bit line control circuit 27 is connected to the bit line BL. The word line control circuit 29 is connected to the word line WL. The sense amplifier 30 is connected to the source line SL. Since a basic configuration itself of such a memory is known, it will be briefly described below.

The I/O 21 enables exchange of a command related to reading and writing of data, an address of the memory cell 10 to be accessed, data, and the like between an external circuit (for example, a CPU or the like) of the storage device 100 and the control circuit 22 of the storage device 100.

The control circuit 22 performs control related to writing and reading of data in the memory cell 10 in response to the command.

The voltage generation circuit 23 generates a voltage (for example, a pulse voltage) used to read and write data from and to the memory cell 10. Note that it is assumed that a voltage necessary for circuit operation is separately provided.

The write circuit 24 controls a voltage and a current (for example, a pulse voltage and a pulse current) used for writing data to the memory cell 10. The write circuit 24 includes a constant current generation circuit 241. The constant current generation circuit 241 will be described in detail later. The write circuit 24 functions as a write unit.

The read circuit 25 controls a voltage (for example, a pulse voltage) used for reading data from the memory cell 10, specifically, for detecting a resistance value of the magnetoresistive element 11.

The bit line address decoder 26 obtains an address of the bit line BL corresponding to the address received by the I/O 21 described above.

The bit line control circuit 27 selects and controls the bit line BL corresponding to the address of the bit line address decoder 26. For example, writing of data to the memory cell 10 by the write circuit 24 and reading of data from the memory cell 10 by the read circuit 25 are performed via the bit line control circuit 27 and the like.

The word line address decoder 28 obtains an address of the word line WL corresponding to the address received by the I/O 21 described above.

The word line control circuit 29 selects and controls the word line WL corresponding to the address of the word line address decoder 28.

The sense amplifier 30 detects data read from the memory cell 10 by the read circuit 25, specifically, the resistance value of the magnetoresistive element 11.

### <1-2. Configuration Example of Memory Cell>

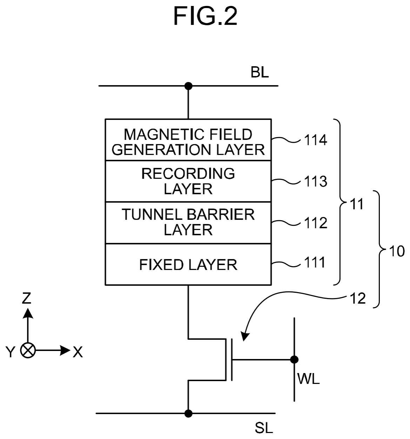

A configuration example of the memory cell 10 according to the present embodiment will be described with reference to FIG. 2. FIG. 2 is a diagram illustrating the configuration example of the memory cell 10 according to the present embodiment.

As illustrated in FIG. 2, the memory cell 10 includes the magnetoresistive element 11 and the selection element 12. The magnetoresistive element 11 and the selection element 12 are connected in series between the bit line BL and the source line SL.

The magnetoresistive element 11 is, for example, an MTJ element having a VCMA effect, and has a stacked structure. In the example of FIG. 2, an XYZ coordinate system for the magnetoresistive element 11 is illustrated for convenience of description. An X-axis direction and a Y-axis direction correspond to a plane direction of a layer. The X-axis direction, the Y-axis direction, and an XY plane direction are also referred to as a horizontal direction. A Z-axis direction corresponds to a direction (stacking direction) perpendicular to the plane direction of the layer. The Z-axis direction is also referred to as a perpendicular direction.

The magnetoresistive element 11 includes a fixed layer 111, a tunnel barrier layer 112, a recording layer 113, and a magnetic field generation layer 114. In this example, the fixed layer 111, the tunnel barrier layer 112, the recording layer 113, and the magnetic field generation layer 114 are stacked in this order in a Z-axis positive direction. Various known materials may be used as the material of each layer.

The fixed layer 111 is a magnetic layer whose magnetization direction is fixed, and is also referred to as a reference layer or the like. It is assumed that the magnetization of the fixed layer 111 is fixed, for example, in the Z-axis positive direction.

The tunnel barrier layer 112 is a nonmagnetic layer provided between the fixed layer 111 and the recording layer 113.

The recording layer 113 is a magnetic layer whose magnetization direction changes, and is also referred to as a free layer or the like. The magnetization of the recording layer 113 changes, for example, between the Z-axis positive direction and a Z-axis negative direction.

Note that the arrangement of the fixed layer 111 and the recording layer 113 may be opposite to that in the example illustrated in FIG. 2. In that case, the recording layer 113, the tunnel barrier layer 112, and the fixed layer 111 are stacked in this order in the Z-axis positive direction.

The magnetic field generation layer 114 generates a horizontal magnetic field. That is, the memory cell 10 is configured such that the recording layer 113 is placed in a magnetic field (horizontal magnetic field) in the plane direction (XY plane direction) of the layer. In the example of FIG. 2, the magnetic field generation layer 114 is provided on the side opposite to the tunnel barrier layer 112 with the recording layer 113 interposed therebetween.

Note that the magnetic field generation layer 114 may be provided on the side opposite to the tunnel barrier layer 112 with the fixed layer 111 interposed therebetween. In addition, a method other than the magnetic field generation layer 114 may be used for generating the horizontal magnetic field. For example, a magnetic field may be generated by forming a magnet layer above (the Z-axis positive direction side) or below (the Z-axis negative direction side) the magnetoresistive element 11. A magnetic field may be generated by disposing a permanent magnet in the periphery.

The selection element 12 is, for example, a field effect transistor (FET). One of a drain terminal and a source terminal of the selection element 12 is connected to the magnetoresistive element 11. The other of the drain terminal and the source terminal of the selection element 12 is connected to the source line SL. A gate terminal of the selection element 12 is connected to the word line WL. When a voltage signal from the word line WL is applied to the gate of the selection element 12 and the selection element 12 is turned on (the drain and the source are brought into a conductive state), the magnetoresistive element 11 is connected to the bit line BL and the source line SL, and a voltage, a current, or the like is applied to the magnetoresistive element 11.

By switching the state of the magnetoresistive element 11 between a low resistance state and a high resistance state, data is written to the memory cell 10. The low resistance state is a state (state 0) in which the magnetization of the fixed layer 111 and the magnetization of the recording layer 113 are parallel to each other, and is a state (state 1) in which the magnetization of the fixed layer 111 and the magnetization of the recording layer 113 are antiparallel to each other. For example, by reversing the magnetization direction of the recording layer 113 between the Z-axis positive direction and the Z-axis negative direction, the state (resistance value) of the magnetoresistive element 11 is switched between the low resistance state (low resistance value) and the high resistance state (high resistance value). The magnetoresistive element 11 is an MTJ element capable of reversing the magnetization of the recording layer 113 by using a VCMA effect. Note that for example, data corresponding to the low resistance state is 0, and data corresponding to the high resistance state is 1.

### <1-3. Configuration Example of Constant Current Generation Circuit>

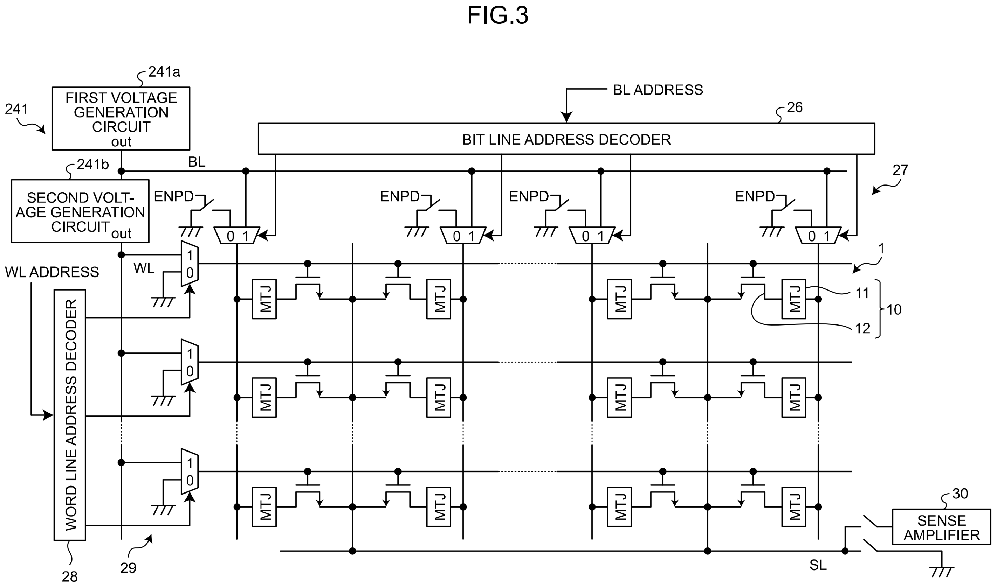

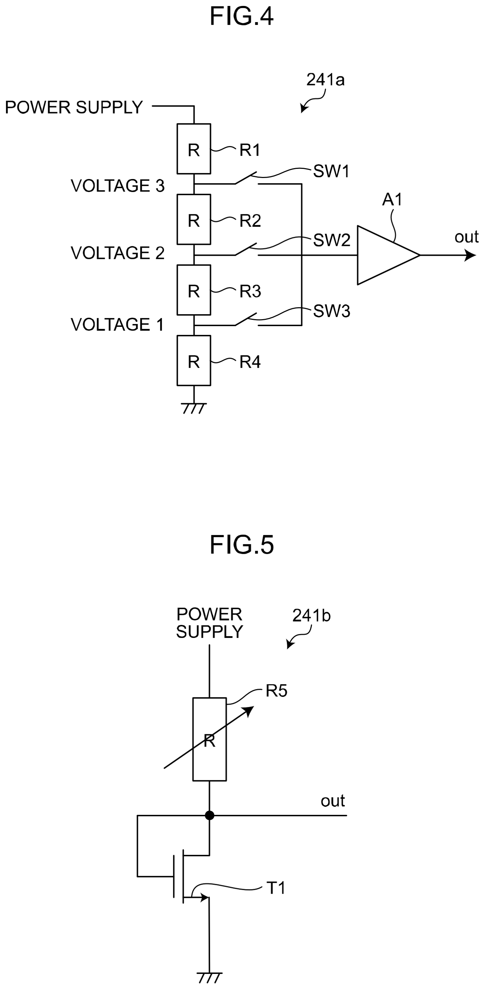

A configuration example of the constant current generation circuit 241 according to the present embodiment will be described with reference to FIGS. 3 to 5. FIG. 3 is a diagram illustrating the configuration example of the constant current generation circuit 241 according to the present embodiment. FIG. 4 is a diagram illustrating a configuration example of a first voltage generation circuit 241a according to the present embodiment. FIG. 5 is a diagram illustrating a configuration example of a second voltage generation circuit 241b according to the present embodiment.

As illustrated in FIG. 3, the constant current generation circuit 241 includes the first voltage generation circuit 241a and the second voltage generation circuit 241b. The constant current generation circuit 241 generates constant currents (first current and second current) used for writing.

The first voltage generation circuit 241a is a circuit that generates a first voltage. The first voltage generation circuit 241a is connected to each of the magnetoresistive elements 11 via the bit line BL and the bit line control circuit 27.

The second voltage generation circuit 241b is a circuit that generates a second voltage. The second voltage generation circuit 241b is connected to each of the selection elements 12 via the word line WL and the word line control circuit 29.

The bit line address decoder 26 has a function of connecting (turning on), to the first voltage generation circuit 241a, only the bit line BL of the memory cell 10 to be accessed and unconnecting (turning off) the other bit lines BL with respect to an address instructed from the control circuit 22.

The bit line control circuit 27 passes a write signal (programming signal) only for the bit line BL to be accessed from the control signal of the bit line address decoder 26. Note that a potential applied to the bit line BL that is not accessed can be switched to a GND potential (ground potential) or a floating potential.

The word line address decoder 28 has a function of connecting (turning on), to the second voltage generation circuit 241b, only the word line WL of the memory cell 10 to be accessed and unconnecting (turning off) the other word lines WL with respect to the address instructed from the control circuit 22.

The word line control circuit 29 turns on the selection element 12 only for the word line WL to be accessed from the control signal of the word line address decoder 28. The GND potential is applied to the word line WL that is not accessed, and the selection element 12 is turned off. Instead of the GND potential, a negative voltage may be used as long as the selection element 12 can be turned off.

Note that the source line SL is connected to the GND at the time of writing (at the time of programming) and is connected to the sense amplifier 30 at the time of reading. Reading is performed, for example, by detecting a current flowing through the memory cell 10 by the sense amplifier 30.

In addition, not a constant current but a voltage may be used for reading, and the voltage may be generated in the same circuit as the circuit that generates a constant current. That is, the constant current generation circuit 241 may generate a constant current for programming and may further generate a voltage for reading. It is assumed that a power supply voltage is supplied.

As illustrated in FIG. 4, the first voltage generation circuit 241a includes a plurality of resistors R1, R2, R3, and R4, a plurality of switches SW1, SW2, and SW3, and an amplifier A1. The first voltage generation circuit 241a has a function of outputting a plurality of voltages having different magnitudes. That is, the first voltage generation circuit 241a can switch the voltages with the switches SW1, SW2, and SW3 and output the voltage to the bit line BL and the second voltage generation circuit 241b. In the example of FIG. 4, a voltage 1, a voltage 2, and a voltage 3 having different magnitudes can be output (voltage 3 > voltage 2 > voltage 1).

As illustrated in FIG. 5, the second voltage generation circuit 241b includes a variable resistor R5 and a transistor T1. The second voltage generation circuit 241b can change the resistance value of the variable resistor R5, and can output different voltages depending on the resistance value. The second voltage generation circuit 241b inputs the output voltage to the gate terminal of the selection element 12 of the memory cell 10. The transistor T1 of the second voltage generation circuit 241b and the selection element 12 constitute a current mirror, and the same current as the current flowing through the second voltage generation circuit 241b is caused to flow through the magnetoresistive element 11.

Setting of the first voltage generation circuit 241a and setting of the second voltage generation circuit 241b are different between a case where the state of the magnetoresistive element 11 is programmed from the high resistance state to the low resistance state and a case where the state of the magnetoresistive element 11 is programmed from the low resistance state to the high resistance state. In the case of programming the state of the magnetoresistive element 11 from the high resistance state to the low resistance state, the constant current flowing through the magnetoresistive element 11 is made smaller than that in the case of programming the state of the magnetoresistive element 11 from the low resistance state to the high resistance state.

When the state of the magnetoresistive element 11 is programmed from the high resistance state to the low resistance state, the first voltage generation circuit 241a sets the voltage 2 illustrated in FIG. 4. The second voltage generation circuit 241b sets the resistance to be higher than an initial resistance value. A current value at this time is defined as a low constant current I_{const} (L) .

When the state of the magnetoresistive element 11 is programmed from the low resistance state to the high resistance state, the first voltage generation circuit 241a sets the voltage 3 illustrated in FIG. 4. The voltage 3 is larger than the voltage 2 (voltage 3 > voltage 2). The second voltage generation circuit 241b sets the resistance to be lower than the initial resistance value. A current value at this time is defined as a high constant current I_{const} (H) .

When the state of the magnetoresistive element 11 is read, the first voltage generation circuit 241a sets the voltage 1 illustrated in FIG. 4. The voltage 1 is smaller than the voltage 2 (voltage 1 < voltage 2). The second voltage generation circuit 241b sets the resistance to be lower than the initial resistance value. Note that the read voltage and the reading means are not limited thereto. In addition, in the case of reading, a voltage having a potential opposite to that of programming may be applied.

### <1-4. Processing Example of Write Processing>

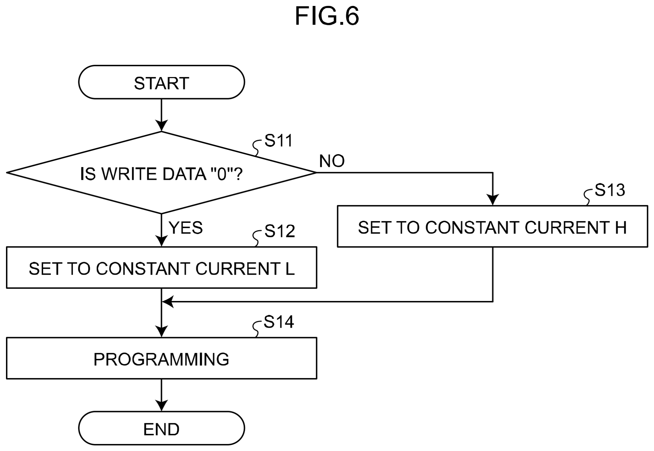

A processing example of write processing according to the present embodiment will be described with reference to FIG. 6. FIG. 6 is a flowchart illustrating a flow of the write processing according to the present embodiment.

The control circuit 22(for example, a state machine included in the control circuit 22) controls the write processing. The flowchart is started by input of a write command and write data input from the I/O 21 to the control circuit 22. Note that for convenience, data corresponding to the low resistance state is 0, and data corresponding to the high resistance state is 1.

In Step S11, it is determined whether or not the write data is 0. When it is determined that the write data is 0 (Yes in Step S11), a constant current L, that is, the low constant current I_{const} (L) is set in the constant current generation circuit 241 in Step S12. That is, a current supplied to the magnetoresistive element 11 is set to the low constant current I_{const} (L). The low constant current I_{const} (L) is a current for bringing the magnetoresistive element 11 into the low resistance state, and is generated by the constant current generation circuit 241.

On the other hand, when it is determined in Step S11 that the write data is not 0 (No in Step S11), a constant current H, that is, the high constant current I_{const} (H) is set in the constant current generation circuit 241 in Step S13. That is, the current supplied to the magnetoresistive element 11 is set to the high constant current I_{const} (H). The high constant current I_{const} (H) is a current for bringing the magnetoresistive element 11 into the high resistance state, and is generated by the constant current generation circuit 241.

In Step S14, programming is executed using the set constant current L (low constant current I_{const} (L)) or constant current H (high constant current I_{const} (H)). The programming is writing, and data is written to the target magnetoresistive element 11. As a result, the write processing ends.

### <1-5. Timing Chart of Write Processing>

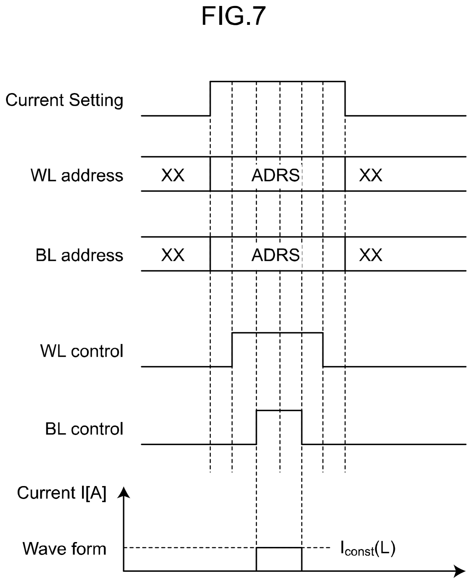

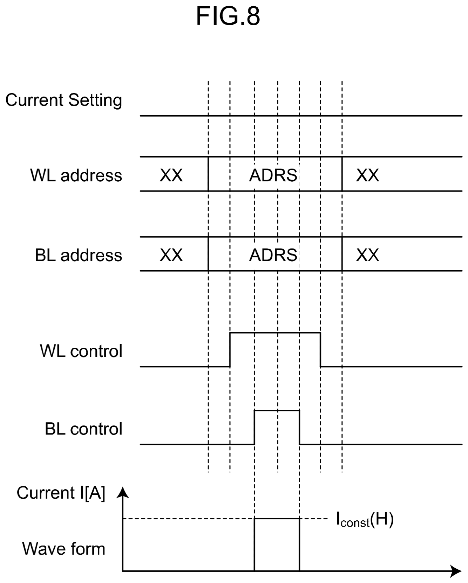

A timing chart of the write processing according to the present embodiment will be described with reference to FIGS. 7 and 8. FIG. 7 is a diagram illustrating a timing chart of the write processing with the low constant current I_{const} (L) according to the present embodiment. FIG. 8 is a diagram illustrating a timing chart of the write processing with the high constant current I_{const} (H) according to the present embodiment.

In Step S12 or Step S13 illustrated in FIG. 6, the control circuit 22 transmits the setting of the low constant current I_{const} (L) or the high constant current I_{const} (H) to the constant current generation circuit 241, and transmits addresses to be programmed to the word line address decoder 28 and the bit line address decoder 26.

Specifically, as illustrated in FIG. 7, when the signal of Current Setting is turned on, the control circuit 22 transmits the setting of the low constant current I_{const} (L) to the constant current generation circuit 241, transmits an address (WL address: ADRS) to be programmed to the word line address decoder 28, and transmits an address (BL address: ADRS) to be programmed to the bit line address decoder 26.

The constant current generation circuit 241 outputs a signal to the word line WL and the bit line BL according to the setting sent from the control circuit 22. This signal is a signal of a pulse current of the low constant current I_{const} (L). The pulse current is a current in which a current value changes in a pulse shape.

The word line address decoder 28 decodes the address input from the control circuit 22 and turns on the corresponding word line WL (WL control). This turning on is to connect the corresponding word line WL and the constant current generation circuit 241.

The bit line address decoder 26 decodes the address input from the control circuit 22 and turns on the corresponding bit line BL (BL control). This turning on is to connect the corresponding bit line BL and the constant current generation circuit 241.

When both the word line WL and the bit line BL are turned on, the low constant current I_{const} (L) is supplied only to the magnetoresistive element 11 of the corresponding address (Wave form). The low constant current I_{const} (L) is a pulse current.

As illustrated in FIG. 8, when the signal of Current Setting is turned off, the control circuit 22 transmits the setting of the high constant current I_{const} (H) to the constant current generation circuit 241, transmits an address (WL address: ADRS) to be programmed to the word line address decoder 28, and transmits an address (BL address: ADRS) to be programmed to the bit line address decoder 26.

The following processing is similar to the processing of FIG. 7, but when both the word line WL and the bit line BL are turned on, the high constant current I_{const} (H) is supplied only to the magnetoresistive element 11 of the corresponding address (Wave form). The high constant current I_{const} (H) is a pulse current.

Here, as illustrated in FIGS. 7 and 8, the high constant current I_{const} (H) is larger than the low constant current I_{const} (L). That is, a larger current is supplied at the time of programming from the low resistance state to the high resistance state than at the time of programming from the high resistance state to the low resistance state.

Note that the low constant current I_{const} (L) and the high constant current I_{const} (H) are pulse currents, but are not limited thereto. In addition, the pulse width of the pulse current is desirably, for example, 0.1 ns or more and 20 ns or less. When the pulse width is 0.1 ns or more, precession reliably occurs, and when the pulse width is 20 ns or less, precession settles (stabilizes); but when the pulse width exceeds 20 ns, precession ends with magnetization completely directed to an external magnetic field direction.

### <1-6. Behavior of Magnetization Vector by Constant Current>

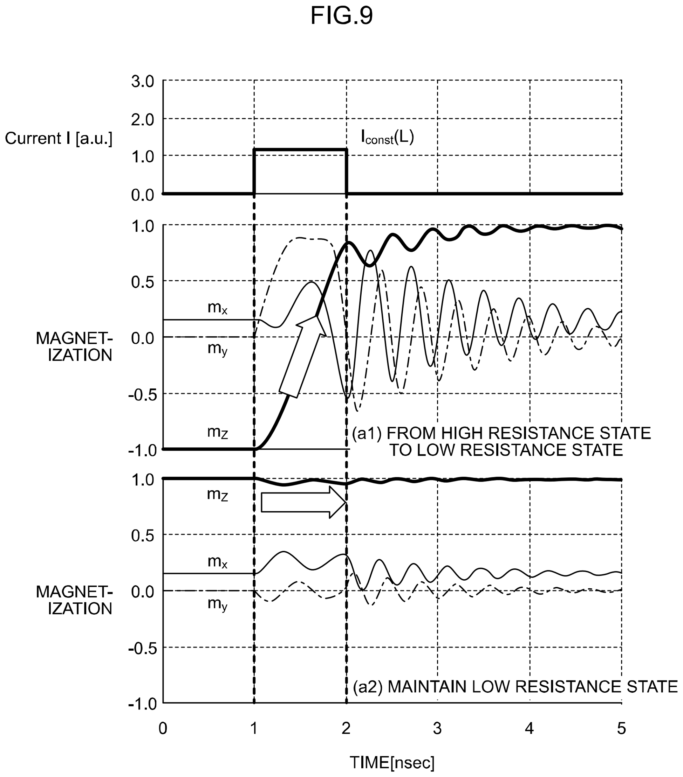

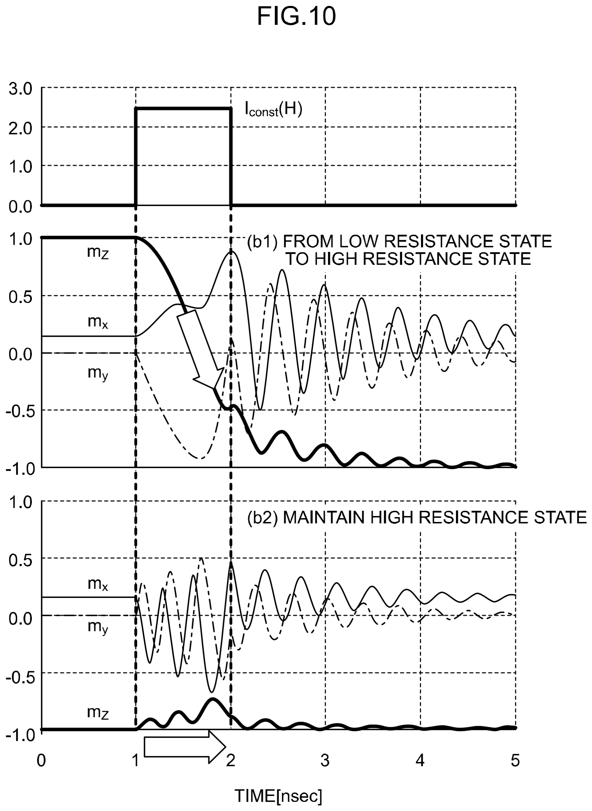

The behavior of a magnetization vector by the constant current according to the present embodiment will be described with reference to FIGS. 9 and 10. FIG. 9 is a diagram illustrating the behavior of the magnetization vector when the low constant current I_{const} (L) is caused to flow through the magnetoresistive element 11 according to the present embodiment. FIG. 10 is a diagram illustrating the behavior of the magnetization vector when the high constant current I_{const} (H) is caused to flow through the magnetoresistive element 11 according to the present embodiment.

In the examples of FIGS. 9 and 10, the magnetization vector is (mₓ, m_{y}, m_{z}). When the magnetization vector is positive in the z-axis direction (m_{z} > 0), it indicates the low resistance state, and when the magnetization vector is negative in the z-axis direction (m_{z} < 0), it indicates the high resistance state.

The graph (middle graph) of (a1) and the graph (lower graph) of (a2) in FIG. 9 illustrate the behavior of the magnetization vector (mₓ, m_{y}, m_{z}) when the low constant current I_{const} (L) is applied to the magnetoresistive element 11. The graph (middle graph) of (b1) and the graph (lower graph) of (b2) in FIG. 10 illustrate the behavior of the magnetization vector (mₓ, m_{y}, m_{z}) when the high constant current I_{const} (H) is applied to the magnetoresistive element 11.

In the graph of (a1) in FIG. 9, when the low constant current I_{const} (L) is applied to the magnetoresistive element 11 in the high resistance state (m_{z} < 0), the magnetoresistive element 11 changes from the high resistance state (m_{z} < 0) to the low resistance state (m_{z} > 0).

In the graph (a2) in FIG. 9, even when the low constant current I_{const} (L) is applied to the magnetoresistive element 11 in the low resistance state (m_{z} > 0), the magnetoresistive element 11 does not change from the low resistance state (m_{z} > 0) and maintains the low resistance state (m_{z} > 0).

In the graph (b1) in FIG. 10, when the high constant current I_{const} (H) is applied to the magnetoresistive element 11 in the low resistance state (m_{z} > 0), the magnetoresistive element 11 changes from the low resistance state (m_{z} > 0) to the high resistance state (m_{z} < 0).

In the graph (b2) in FIG. 10, even when the high constant current I_{const} (H) is applied to the magnetoresistive element 11 in the high resistance state (m_{z} < 0), the magnetoresistive element 11 does not change from the high resistance state (m_{z} < 0) and maintains the high resistance state (m_{z} < 0).

As described above, in order to bring the magnetoresistive element 11 into the low resistance state, the low constant current I_{const} (L) only needs to flow through the magnetoresistive element 11, and in order to bring the magnetoresistive element 11 into the high resistance state, the high constant current I_{const} (H) only needs to flow. However, even when the low constant current I_{const} (L) flows through the magnetoresistive element 11 in the low resistance state, magnetization reversal does not occur, and even when the high constant current I_{const} (H) flows through the magnetoresistive element 11 in the high resistance state, magnetization reversal does not occur. Therefore, it is not necessary to determine whether to execute programming (writing) by performing initial reading. In this way, since the initial reading is unnecessary, the write time can be shortened. Furthermore, by shortening the write time, low power consumption can be realized.

### <2. Second Embodiment>

### <2-1. Processing Example of Write Processing>

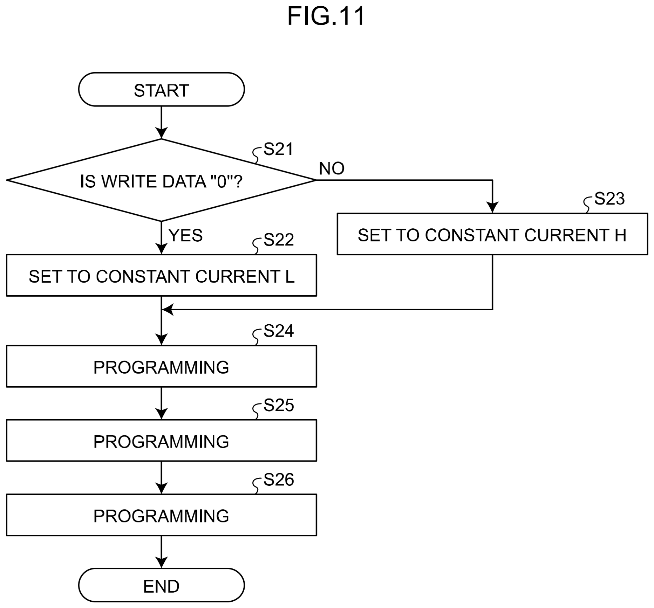

A processing example of write processing according to the present embodiment will be described with reference to FIG. 11. FIG. 11 is a flowchart illustrating a flow of the write processing according to the present embodiment. The present embodiment is basically the same as the first embodiment, and the difference (write processing) will be described.

In the first embodiment, programming (writing) is executed once, but in the present embodiment, programming is executed a plurality of times. As a result, even if one programming fails, a write error rate which is a failure probability of writing can be reduced by trying programming a plurality of times.

As illustrated in FIG. 11, in Step S21, it is determined whether or not write data is 0. When it is determined that the write data is 0 (Yes in Step S21), a constant current L, that is, a low constant current I_{const} (L) is set in a constant current generation circuit 241 in Step S22. That is, a current supplied to a magnetoresistive element 11 is set to the low constant current I_{const} (L) .

On the other hand, when it is determined in Step S21 that the write data is not 0 (No in Step S21), a constant current H, that is, a high constant current I_{const} (H) is set in the constant current generation circuit 241 in Step S23. That is, the current supplied to the magnetoresistive element 11 is set to the high constant current I_{const} (H).

Programming is executed using the set constant current L (low constant current I_{const} (L)) or constant current H (high constant current I_{const} (H)) in Step S24, programming is similarly executed in Step S25, and programming is similarly executed in Step S26. In this way, programming is repeatedly executed three times, and data is written to the target magnetoresistive element 11. As a result, the write processing ends.

According to such write processing, programming is executed several times after setting the constant current L or the constant current H. The number of times of executing programming is arbitrary. For example, assuming that the write error rate of one time is 0.01, if a required write error rate is 1.E-6, programming is executed three times. The number of times of executing programming is set in advance, but may be changed according to, for example, an input operation to an external device such as an input device connected to the storage device 100.

### <2-2. Timing Chart of Write Processing>

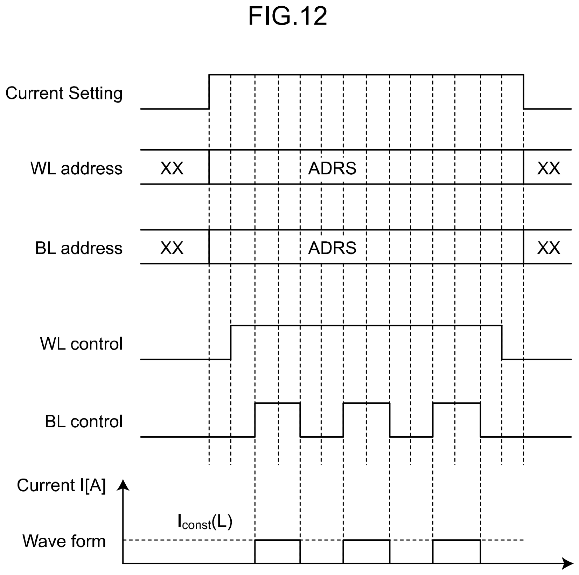

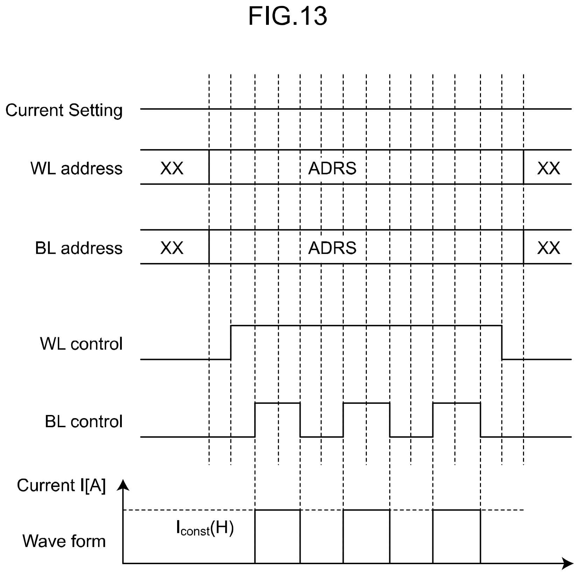

A timing chart of the write processing according to the present embodiment will be described with reference to FIGS. 12 and 13. FIG. 12 is a diagram illustrating a timing chart of the write processing with the low constant current I_{const} (L) according to the present embodiment. FIG. 13 is a diagram illustrating a timing chart of the write processing with the high constant current I_{const} (H) according to the present embodiment.

The timing chart illustrated in FIG. 12 is basically the same as the timing chart illustrated in FIG. 7, but in FIG. 12, a bit line BL is turned on three times while a word line WL is turned on. As a result, the low constant current I_{const} (L) is supplied three times only to the magnetoresistive element 11 of the corresponding address (Wave form). That is, programming is executed three times. As a result, the write error rate can be reduced.

The timing chart illustrated in FIG. 13 is basically the same as the timing chart illustrated in FIG. 8, but in FIG. 13, the bit line BL is turned on three times while the word line WL is turned on. As a result, the high constant current I_{const} (H) is supplied three times only to the magnetoresistive element 11 of the corresponding address (Wave form). That is, programming is executed three times. As a result, the write error rate can be reduced.

Note that the pulse widths of the pulse currents of the low constant current I_{const} (L) and the high constant current I_{const} (H) are constant, but are not limited thereto, and may be different for each supply (application) of the pulse current. Since the optimum write pulse width may vary among the magnetoresistive elements 11 in a memory cell array 1, it is possible to reduce the write error rate by performing writing with different pulse widths a plurality of times.

### <2-3. Modification 1 of Write Processing>

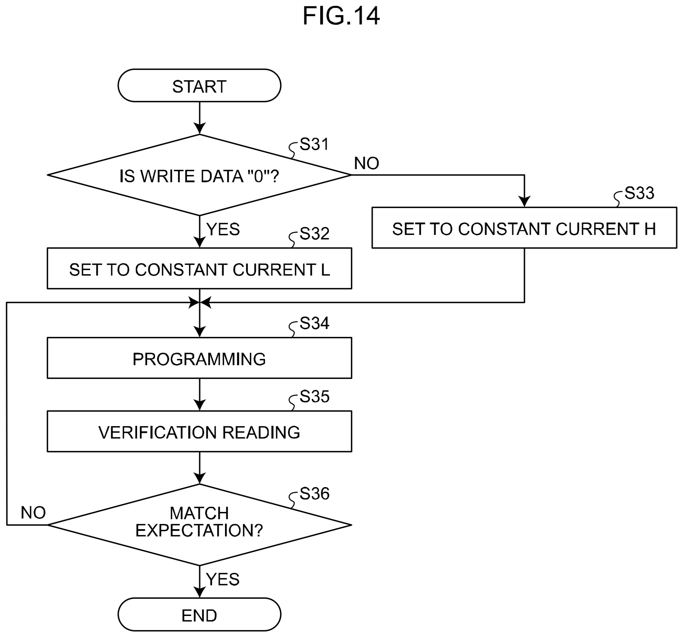

Modification 1 of the write processing according to the present embodiment will be described with reference to FIG. 14. FIG. 14 is a flowchart illustrating a flow of write processing according to Modification 1. Modification 1 is basically the same as the first embodiment, and the difference (write processing) will be described.

In Modification 1, verification may be performed for each programming. For example, in a case where the power consumption necessary for reading is lower than the power consumption necessary for programming, it is possible to reduce the execution of excessive programming, and thus, it is possible to realize the reduction of the power consumption.

As illustrated in FIG. 14, in Step S31, it is determined whether or not write data is 0. When it is determined that the write data is 0 (Yes in Step S31), the constant current L, that is, the low constant current I_{const} (L) is set in the constant current generation circuit 241 in Step S32. That is, a current supplied to a magnetoresistive element 11 is set to the low constant current I_{const} (L) .

On the other hand, when it is determined in Step S31 that the write data is not 0 (No in Step S31), the constant current H, that is, the high constant current I_{const} (H) is set in the constant current generation circuit 241 in Step S33. That is, the current supplied to the magnetoresistive element 11 is set to the high constant current I_{const} (H) .

In Step S34, programming is executed using the set constant current L (low constant current I_{const} (L)) or constant current H (high constant current I_{comst} (H)). As a result, data is written to the target magnetoresistive element 11.

In Step S35, verification reading is executed, and in Step S36, it is determined whether or not the read data matches an expectation (expected value). The read data is read from the target magnetoresistive element 11 by verification reading. The expected value is a value of write data.

When it is determined in Step S36 that the read write data does not match the expectation (expected value) (No in Step S36), the processing returns to Step S34. On the other hand, when it is determined that the read write data matches the expectation (expected value) (Yes in Step S36), the write processing ends.

According to such write processing, programming is executed after setting the constant current L or the constant current H, and programming is repeatedly executed until the writing is successful. As a result, it is possible to reduce the execution of excessive programming and realize the reduction of power consumption while suppressing the write error rate.

### <2-4. Modification 2 of Write Processing>

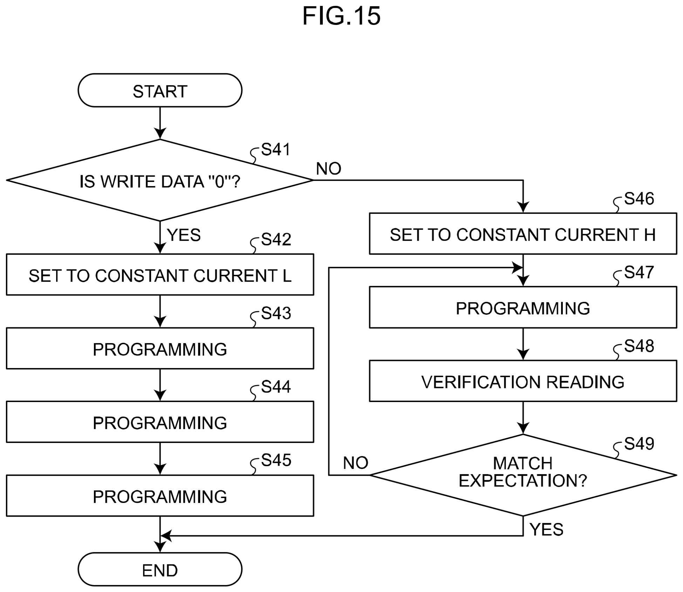

Modification 2 of the write processing according to the present embodiment will be described with reference to FIG. 15. FIG. 15 is a flowchart illustrating a flow of write processing according to Modification 2. Modification 2 is basically the same as the first embodiment, and the difference (write processing) will be described.

In Modification 2, programming (writing) is repeatedly executed on the constant current L side, and verification is performed for each programming on the constant current H side. For example, in a case where the probability that the high resistance state cannot be maintained by the application of the high constant current I_{const} (H) is high, execution of excessive programming can be reduced by performing verification, and the probability of occurrence of unexpected inversion can be reduced.

As illustrated in FIG. 15, in Step S41, it is determined whether or not write data is 0. When it is determined that the write data is 0 (Yes in Step S41), the constant current L, that is, the low constant current I_{const} (L) is set in the constant current generation circuit 241 in Step S42. That is, a current supplied to a magnetoresistive element 11 is set to the low constant current I_{const} (L).

Programming is executed using the set constant current L (low constant current I_{const} (L)) in Step S43, programming is similarly executed in Step S44, and programming is similarly executed in Step S45. In this way, programming is repeatedly executed three times, and data is written to the target magnetoresistive element 11. As a result, the write processing ends.

On the other hand, when it is determined in Step S41 that the write data is not 0 (No in Step S41), the constant current H, that is, the high constant current I_{const} (H) is set in the constant current generation circuit 241 in Step S46. That is, the current supplied to the magnetoresistive element 11 is set to the high constant current I_{const} (H).

In Step S47, programming is executed using the set constant current H (high constant current I_{const} (H)). As a result, data is written to the target magnetoresistive element 11.

In Step S48, verification reading is executed, and in Step S49, it is determined whether or not the read data matches an expectation (expected value). The read data is read from the target magnetoresistive element 11 by verification reading. The expected value is a value of write data.

When it is determined in Step S49 that the read write data does not match the expectation (expected value) (No in Step S49), the processing returns to Step S47. On the other hand, when it is determined that the read write data matches the expectation (expected value) (Yes in Step S49), the write processing ends.

According to such write processing, verification reading is performed after programming from the low resistance state to the high resistance state, if the read data matches the expected value, programming ends, and if not, programming is repeated. In addition, programming from the high resistance state to the low resistance state is executed a plurality of times without executing verification reading. In this way, by performing verification reading while suppressing the write error rate, it is possible to reduce the execution of excessive programming and reduce the probability of occurrence of unexpected inversion.

### <3. Third Embodiment>

### <3-1. Configuration Example of First Voltage Generation Circuit>

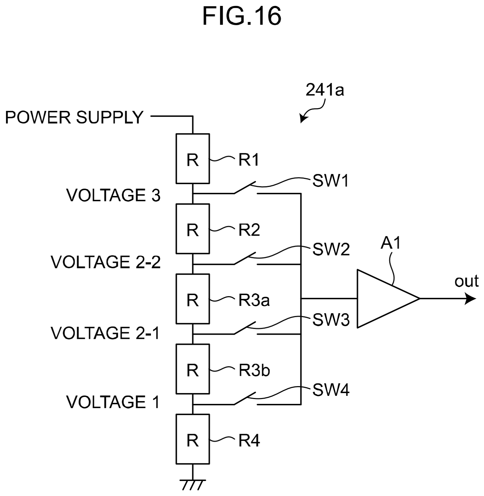

A configuration example of a first voltage generation circuit 241a according to the present embodiment will be described with reference to FIG. 16. FIG. 16 is a diagram illustrating the configuration example of the first voltage generation circuit 241a according to the present embodiment. The present embodiment is basically the same as the first embodiment, and the differences (the first voltage generation circuit 241a and write processing) will be described.

In the first embodiment (or the second embodiment), one constant current setting is provided for each of the case of programming from the high resistance state to the low resistance state and the case of programming from the low resistance state to the high resistance state. On the other hand, in the present embodiment, a plurality of constant current settings for programming from the high resistance state to the low resistance state are provided, and the current is switched in the middle of a pulse of a pulse current.

As illustrated in FIG. 16, the first voltage generation circuit 241a includes a plurality of resistors R1, R2, R3a, R3b, and R4, a plurality of switches SW1, SW2, SW3, and SW4, and an amplifier A1. The first voltage generation circuit 241a has a function of outputting a plurality of voltages having different magnitudes. That is, the first voltage generation circuit 241a can switch the voltages with the switches SW1, SW2, SW3, and SW4 and output the voltage to a bit line BL and a second voltage generation circuit 241b. In the example of FIG. 16, a voltage 1, voltages 2-1 and 2-2, and a voltage 3 having different magnitudes can be output (voltage 3 > voltage 2-2 > voltage 2-1 > voltage 1). Note that the first voltage generation circuit 241a has a plurality of settings for programming from the high resistance state to the low resistance state. That is, the first voltage generation circuit 241a divides a pulse into the first half and the second half, and makes a constant current value larger in the second half than in the first half. Note that the second voltage generation circuit 241b has a configuration similar to that of the first embodiment.

When the state of a magnetoresistive element 11 is programmed from the high resistance state to the low resistance state, the first voltage generation circuit 241a sets the voltage 2-1 illustrated in FIG. 16 in the first half of the pulse of the pulse current. The second voltage generation circuit 241b sets the resistance to be higher than an initial resistance value. A current value at this time is defined as a low constant current I_{const} (L-1). The first voltage generation circuit 241a sets the voltage 2-2 illustrated in FIG. 16 in the second half of the pulse of the pulse current (voltage 2-2 > voltage 2-1). The second voltage generation circuit 241b sets the resistance to be lower than that in the first half of the pulse. A current value at this time is defined as a low constant current I_{const} (L-2). The low constant current I_{const} (L-2) is larger than the low constant current I_{const} (L-1). In this manner, the first voltage generation circuit 241a divides the pulse into the first half and the second half, and makes the current value larger in the second half than in the first half.

### <3-2. Timing Chart of Write Processing>

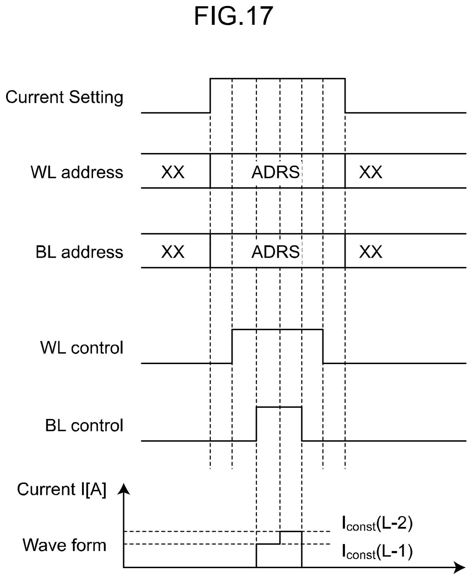

A timing chart of write processing according to the present embodiment will be described with reference to FIG. 17. FIG. 17 is a diagram illustrating a timing chart of the write processing with the low constant current I_{const} (L) according to the present embodiment. Note that the present embodiment is different from the first embodiment only in the case of programming from the high resistance state to the low resistance state.

The timing chart illustrated in FIG. 17 is basically the same as the timing chart illustrated in FIG. 7, but in FIG. 17, the constant current is switched from I_{const} (L-1) to I_{const} (L-2) while the bit line BL is turned on. I_{const} (L-2) is larger than I_{const} (L-1) (I_{const} (L-2) > I_{const} (L-1)). As a result, the write error rate from the high resistance state to the low resistance state can be reduced. The effect of the current value switching in the middle of the pulse will be described below.

### (Effect of Current Value Switching in Middle of Pulse)

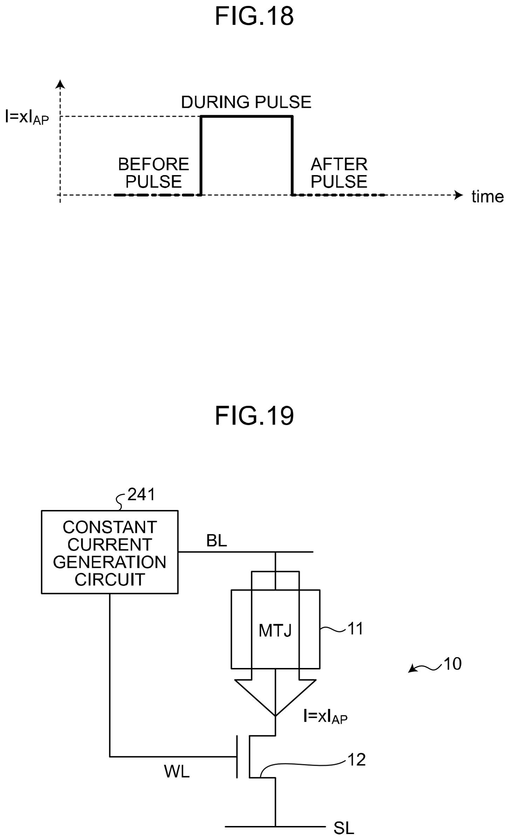

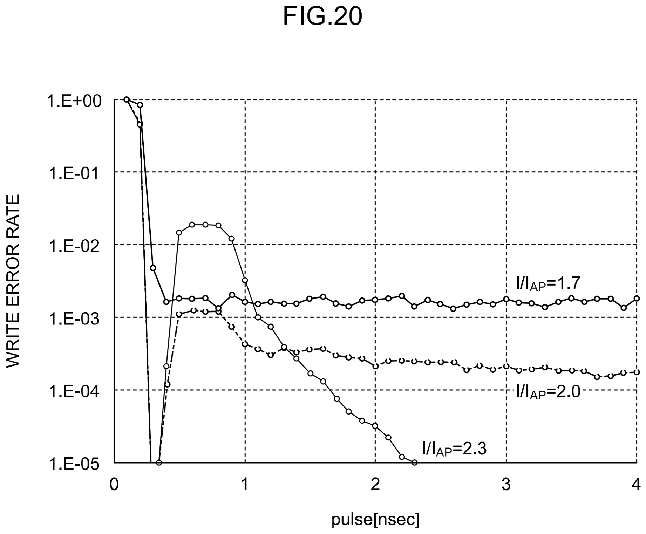

Here, a pulse current (I = xI_{AP}) illustrated in FIG. 18 is caused to flow through the magnetoresistive element 11 as illustrated in FIG. 19, a relationship between a pulse width and a write error rate for each pulse current is obtained, and the relationship is illustrated in FIG. 20. FIG. 18 is a diagram illustrating the pulse current according to the present embodiment. FIG. 19 is a diagram illustrating a memory cell 10 and a constant current generation circuit 241 according to the present embodiment. FIG. 20 is a diagram illustrating a relationship between a pulse width and a write error rate for each pulse current (constant current value) according to the present embodiment.

I_{AP} is a current value flowing through the magnetoresistive element 11 in the high resistance state. A constant current I that is x times the current I_{AP} is caused to flow through the magnetoresistive element 11. The numbers (1.7, 2.0, and 2.3) in FIG. 20 are x (= I/I_{AP}). Note that it is assumed that a resistance value R_{AP} in the high resistance state is three times a resistance value R_{P} in the low resistance state (R_{AP} = 3 × R_{P}).

The waveform of number 2.3 in FIG. 20 decreases after the write error rate increases. The waveform of number 2.0 in FIG. 20 is stabilized after the write error rate increases. In both cases, it has been found that the direction of the magnetization vector remains stationary at an intermediate position that is neither the +Z direction nor the -Z direction during the pulse.

In a waveform in which the write error rate continues to decrease, for example, in the waveform of number 2.3 in FIG. 20, the direction of the magnetization vector temporarily remains stationary when the pulse width is 0.0 nsec to 1.8 nsec, but the direction of the magnetization vector gets out of the steady state due to noise fluctuation when the pulse width is 1.8 nsec to 2.5 nsec. That is, it has been found that although the direction of the magnetization vector temporarily remains stationary, the magnetization vector may jump out due to fluctuation when left standing. The larger the current, the larger the fluctuation. Therefore, the degradation of the write error rate can be suppressed by suppressing the current at the beginning. On the other hand, in order to get out of the steady state, it is effective to increase the current.

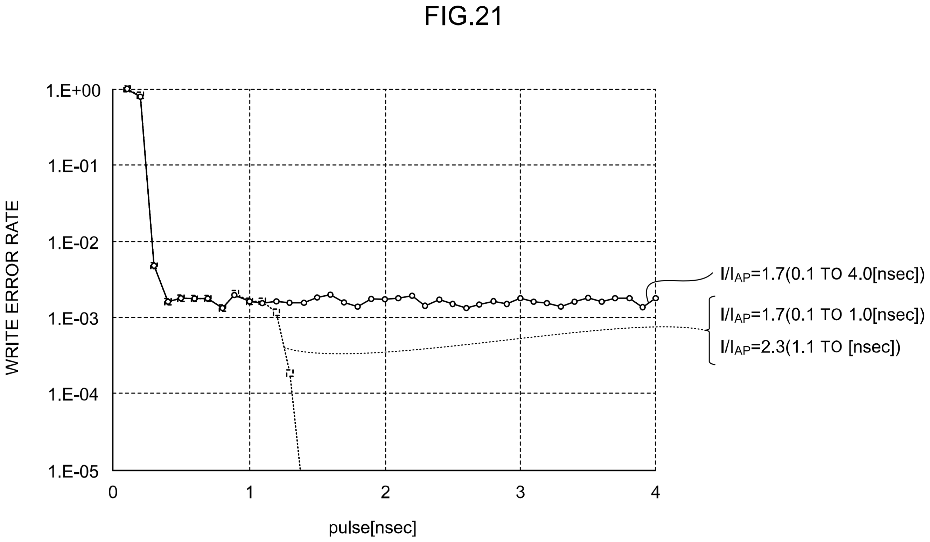

FIG. 21 is a diagram illustrating a relationship between a pulse width and a write error rate for each pulse current (constant current value and switching current value) according to the present embodiment. In the example of FIG. 21, I/I_{AP} corresponds to x (I/I_{AP} = x).

As illustrated in FIG. 21, in the waveform of I/I_{AP} = 1.7 (0.1 to 4.0 nsec), the write error rate is constant around 0.002. In the waveforms of I/I_{AP} = 1.7 (0.1 to 1.0 nsec) and 2.3 (1.1 nsec or more), the write error rate decreases from around 1.2 nsec to reach 1.E-05 around 1.4 nsec. This waveform is obtained by increasing the current value of the pulse current stepwise.

By increasing the current value of the pulse current stepwise in this manner, the write error rate can be reduced. That is, as described above, by suppressing the current value at the beginning of the pulse current and increasing the current value in the middle of the pulse (see FIG. 17), the write error rate from the high resistance state to the low resistance state can be reduced, for example. Therefore, it is more effective to increase the current value of the pulse current stepwise. This stepwise increase in the current value makes it possible to get out of an error state of remaining at a halfway stable point. In addition, even if the pulse width is a long pulse, the write error rate is not deteriorated, so that it is possible to avoid control in a short time. Note that in order to shorten the write processing time, it is desirable that the pulse width be short.

### <4. Fourth Embodiment>

### <4-1. Processing Example of Write Processing>

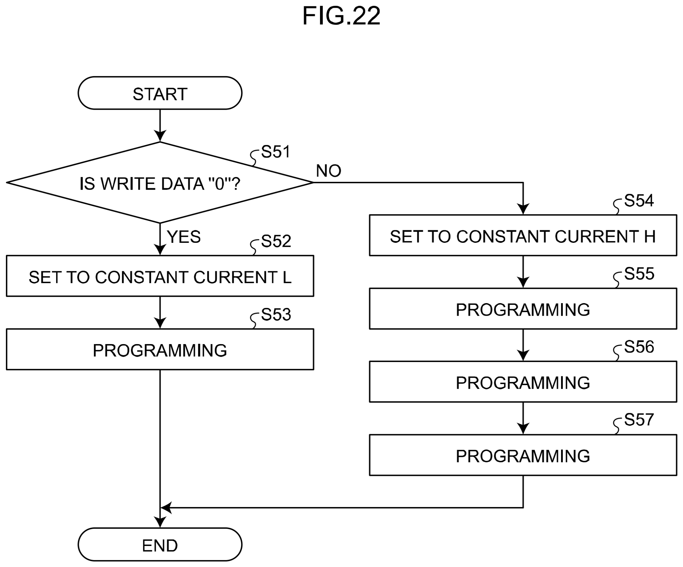

A processing example of write processing according to the present embodiment will be described with reference to FIG. 22. FIG. 22 is a flowchart illustrating a flow of the write processing according to the present embodiment. The present embodiment is basically the same as the first embodiment, and the difference (write processing) will be described.

In the present embodiment, the third embodiment is applied in the case of programming from the high resistance state to the low resistance state, and the second embodiment is applied in the case of programming from the low resistance state to the high resistance state. As a result, effects similar to those of the third embodiment and the second embodiment can be obtained.

As illustrated in FIG. 22, in Step S51, it is determined whether or not write data is 0. When it is determined that the write data is 0 (Yes in Step S51), a constant current L, that is, a low constant current I_{const} (L) is set in a constant current generation circuit 241 in Step S52. That is, a current supplied to a magnetoresistive element 11 is set to the low constant current I_{const} (L) .

In Step S53, programming is executed using the set constant current L (low constant current I_{const} (L)). Data is written to the target magnetoresistive element 11. As a result, the write processing ends.

On the other hand, when it is determined in Step S51 that the write data is not 0 (No in Step S51), a constant current H, that is, a high constant current I_{const} (H) is set in the constant current generation circuit 241 in Step S54. That is, the current supplied to the magnetoresistive element 11 is set to the high constant current I_{const} (H).

Programming is executed using the set constant current H (high constant current I_{const} (H)) in Step S55, programming is similarly executed in Step S56, and programming is similarly executed in Step S57. In this way, programming is repeatedly executed three times, and data is written to the target magnetoresistive element 11. As a result, the write processing ends.

According to such write processing, programming is executed a plurality of times when programming is performed from the low resistance state to the high resistance state, and programming is executed once when programming is performed from the high resistance state to the low resistance state. However, in the case of programming from the high resistance state to the low resistance state, one programming (the pulse width of a pulse current) may be long as illustrated in the next timing chart.

### <4-2. Timing Chart of Write Processing>

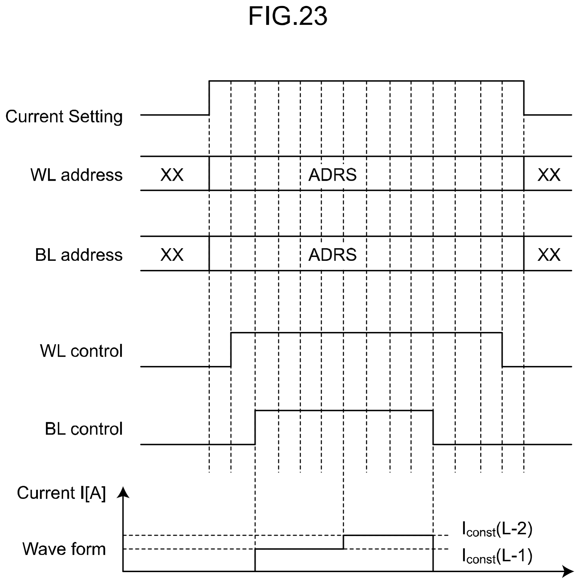

A timing chart of the write processing according to the present embodiment will be described with reference to FIG. 23. FIG. 23 is a diagram illustrating a timing chart of the write processing with the low constant current I_{const} (L) according to the present embodiment.

The timing chart illustrated in FIG. 23 is basically the same as the timing chart illustrated in FIG. 17, but in FIG. 23, one pulse width is longer than that in the third embodiment. When the state of the magnetoresistive element 11 is programmed from the high resistance state to the low resistance state, the constant current is switched from I_{const} (L-1) to I_{const} (L-2) while a bit line BL is turned on as illustrated in FIG. 23. One pulse width is longer than that in the third embodiment, but is not limited thereto, and may be shorter. Note that the case of programming from the low resistance state to the high resistance state is the same as that in the second embodiment (see FIG. 13).

### <5. Operations and Effects according to Each Embodiment>

As described above, according to the present embodiment, the storage device 100 includes the magnetoresistive element 11 whose magnetization direction is variable between the first state and the second state, the selection element 12 connected to the magnetoresistive element 11, and the write unit (for example, the write circuit 24) that switches and supplies, to the magnetoresistive element 11, the first current for bringing the magnetization direction of the magnetoresistive element 11 into the first state and the second current for bringing the magnetization direction of the magnetoresistive element 11 into the second state. As a result, in order to bring the magnetoresistive element 11 into the first state, it is sufficient to cause the first current to flow through the magnetoresistive element 11, and in order to bring the magnetoresistive element 11 into the second state, it is sufficient to cause the second current to flow through the magnetoresistive element. That is, magnetization reversal occurs when the first current flows through the magnetoresistive element 11 in the second state, but magnetization reversal does not occur even when the first current flows through the magnetoresistive element 11 in the first state. Similarly, magnetization reversal occurs when the second current flows through the magnetoresistive element 11 in the first state, but magnetization reversal does not occur even when the second current flows through the magnetoresistive element 11 in the second state. Therefore, it is not necessary to determine whether to execute programming (writing) by performing initial reading, and the initial reading becomes unnecessary, so that the write time can be shortened.

In addition, the first current may be larger than the second current. As a result, the write time can be reliably shortened.

In addition, the write unit may supply a constant current as one or both of the first current and the second current to the magnetoresistive element 11. As a result, the write time can be reliably shortened.

In addition, the write unit may include the constant current generation circuit 241 that generates a constant current. As a result, the write time can be reliably shortened.

In addition, the constant current generation circuit 241 may include the first voltage generation circuit 241a that is connected to the magnetoresistive element 11 and generates a first voltage, and the second voltage generation circuit 241b that is connected to the selection element 12 and generates a second voltage. As a result, the constant current generation circuit 241 can be realized with a simple configuration.

In addition, the first voltage generation circuit 241a may output, as the first voltage, a voltage selected from a plurality of voltages having different magnitudes. As a result, the constant current generation circuit 241 can be realized with a simple configuration.

In addition, the second voltage generation circuit 241b may change a voltage with the variable resistor R5 and output the voltage as the second voltage. As a result, the constant current generation circuit 241 can be realized with a simple configuration.

In addition, the selection element 12 may have the drain terminal, the source terminal, and the gate terminal, one terminal of two terminals of the magnetoresistive element 11 may be connected to the bit line BL, the other terminal may be connected to the drain terminal or the source terminal, the gate terminal may be connected to the word line WL, the first voltage generation circuit 241a may be connected to the bit line BL and the second voltage generation circuit 241b, and the second voltage generation circuit 241b may be connected to the word line WL. As a result, the constant current generation circuit 241 can be realized with a simple configuration.

In addition, the write unit may supply a pulse current as one or both of the first current and the second current to the magnetoresistive element 11. As a result, the write time can be reliably shortened.

In addition, the write unit may repeat the supply of the pulse current to the magnetoresistive element 11 one or more times. As a result, the write error rate can be reduced.

In addition, the write unit may read the state of the magnetization direction of the magnetoresistive element 11 after the supply of the pulse current, and repeat the supply of the pulse current to the magnetoresistive element 11 one or more times when the read state is not a desired state. As a result, the write error rate can be reduced.

In addition, the pulse width of the pulse current may be different for each supply of the pulse current. As a result, the write error rate can be reduced.

In addition, the pulse width of the pulse current may be 0.1 ns or more and 20 ns or less. As a result, the write error rate can be reduced.

In addition, the write unit may change the first current to a third current smaller than the first current in the middle of writing to bring the magnetoresistive element 11 into the first state. As a result, the write error rate can be reduced.

In addition, the write unit may change the second current to a fourth current smaller than the second current in the middle of writing to bring the magnetoresistive element 11 into the second state. As a result, the write error rate can be reduced.

In addition, the write unit may change the first current to the third current smaller than the first current in the middle of writing to bring the magnetoresistive element 11 into the first state, and may change the second current to the fourth current smaller than the second current in the middle of writing to bring the magnetoresistive element 11 into the second state. As a result, the write error rate can be reduced.

In addition, the magnetoresistive element 11 may be an element in which the magnetization direction varies by using the VCMA effect. Even in this case, the write time can be reliably shortened.

### <6. Other Embodiments>

The configurations according to the above embodiments may be implemented in various different forms other than the above embodiments. For example, the configurations are not limited to the above-described examples, and may be various modes. In addition, for example, the configurations, the processing procedures, the specific names, and the information including various data and parameters illustrated in the above-described document or the drawings can be arbitrarily changed unless otherwise specified.

In addition, each component of each device illustrated in the drawings is functionally conceptual, and is not necessarily physically configured as illustrated in the drawings. That is, a specific form of distribution and integration of each device is not limited to the illustrated form, and all or a part thereof can be functionally or physically distributed and integrated in an arbitrary unit according to various loads, usage conditions, and the like.

### <7. Configuration Example of Electronic Apparatus>

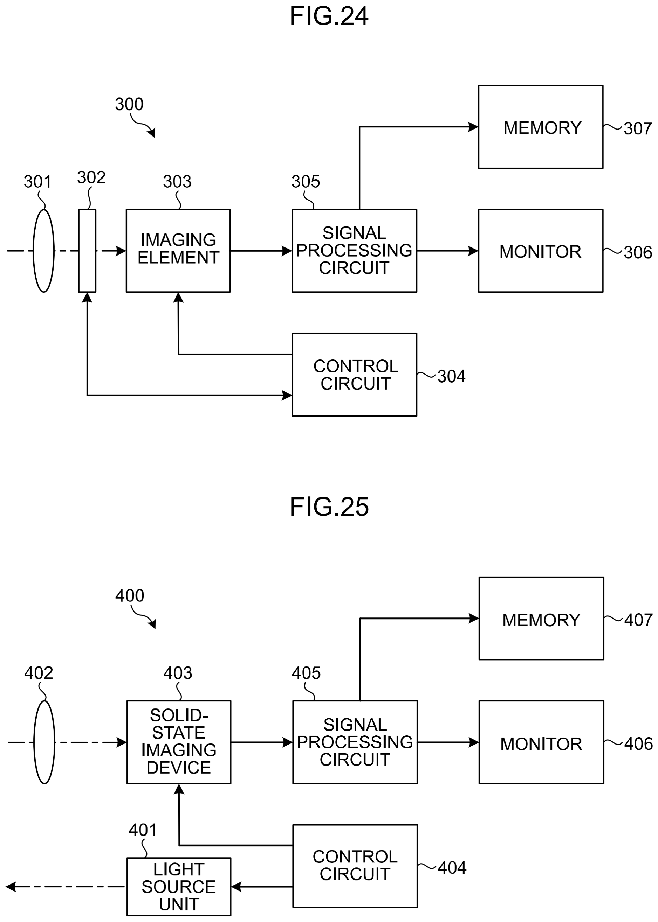

As an electronic apparatus to which the storage device 100 according to the above embodiment (including modifications) is applied, an imaging device 300, a distance measuring device 400, and a game apparatus 900 will be described with reference to FIGS. 24 to 27. For example, each of the imaging device 300, the distance measuring device 400, and the game apparatus 900 uses the storage device 100 according to each of the above embodiments as a memory. Examples of the memory include a flash memory and the like.

### <7-1. Imaging Device>

The imaging device 300 to which the storage device 100 according to the above embodiment is applied will be described with reference to FIG. 24. FIG. 24 is a diagram illustrating an example of a schematic configuration of the imaging device 300. The imaging device 300 is an example of the electronic apparatus to which the storage device 100 according to the present embodiment is applied. Examples of the imaging device 300 include electronic devices such as a digital still camera, a video camera, a smartphone having an imaging function, and a mobile phone.

As illustrated in FIG. 24, the imaging device 300 includes an optical system 301, a shutter device 302, an imaging element 303, a control circuit (drive circuit) 304, a signal processing circuit 305, a monitor 306, and a memory 307. The imaging device 300 can capture a still image and a moving image.

The optical system 301 includes one or a plurality of lenses. The optical system 301 guides light (incident light) from a subject to the imaging element 303 and forms an image on a light receiving surface of the imaging element 303.

The shutter device 302 is disposed between the optical system 301 and the imaging element 303. The shutter device 302 controls a light irradiation period and a light shielding period with respect to the imaging element 303 according to the control of the control circuit 304.

The imaging element 303 accumulates signal charges for a certain period according to light formed on the light receiving surface via the optical system 301 and the shutter device 302. The signal charges accumulated in the imaging element 303 is transferred in accordance with a drive signal (timing signal) supplied from the control circuit 304.

The control circuit 304 outputs the drive signal for controlling a transfer operation of the imaging element 303 and a shutter operation of the shutter device 302 to drive the imaging element 303 and the shutter device 302.

The signal processing circuit 305 performs various types of signal processing on the signal charges output from the imaging element 303. An image (image data) obtained by performing the signal processing by the signal processing circuit 305 is supplied to the monitor 306 and also supplied to the memory 307.

The monitor 306 displays a moving image or a still image captured by the imaging element 303 based on the image data supplied from the signal processing circuit 305. As the monitor 306, for example, a panel type display device such as a liquid crystal panel or an organic electro luminescence (EL) panel is used.

The memory 307 stores the image data supplied from the signal processing circuit 305, that is, image data of the moving image or the still image captured by the imaging element 303. The memory 307 corresponds to the storage device 100 according to the above embodiment.

Also in the imaging device 300 configured in this manner, the write time can be shortened by using the above-described storage device 100 as the memory 307.

### <7-2. Distance Measuring Device>

The distance measuring device 400 to which the storage device 100 according to the above embodiment is applied will be described with reference to FIG. 25. FIG. 25 is a diagram illustrating an example of a schematic configuration of the distance measuring device 400. The distance measuring device 400 is an example of the electronic apparatus to which the storage device 100 according to the present embodiment is applied.

As illustrated in FIG. 25, the distance measuring device (distance image sensor) 400 includes a light source unit 401, an optical system 402, a solid-state imaging device (imaging element) 403, a control circuit (drive circuit) 404, a signal processing circuit 405, a monitor 406, and a memory 407. The distance measuring device 400 can acquire a distance image according to a distance to a subject by projecting light from the light source unit 401 toward the subject and receiving light (modulated light or pulsed light) reflected from a surface of the subject.

The light source unit 401 projects light toward the subject. As the light source unit 401, for example, a vertical cavity surface emitting laser (VCSEL) array that emits laser light as a surface light source or a laser diode array in which laser diodes are arrayed on a line is used. Note that the laser diode array is supported by a predetermined drive unit (not illustrated), and is scanned in a direction perpendicular to the array direction of the laser diodes.

The optical system 402 includes one or a plurality of lenses. The optical system 402 guides light (incident light) from the subject to the solid-state imaging device 403 to form an image on a light receiving surface (sensor unit) of the solid-state imaging device 403.

The solid-state imaging device 403 stores signal charges according to the light of the image formed on the light receiving surface via the optical system 402. A distance signal indicating the distance obtained from a light reception signal (APD OUT) output from the solid-state imaging device 403 is supplied to the signal processing circuit 405. As the solid-state imaging device 403, for example, a solid-state imaging element such as an image sensor is used.

The control circuit 404 outputs a drive signal (control signal) for controlling operations of the light source unit 401, the solid-state imaging device 403, and the like to drive the light source unit 401, the solid-state imaging device 403, and the like.

The signal processing circuit 405 performs various types of signal processing on the distance signal supplied from the solid-state imaging device 403. For example, the signal processing circuit 405 performs image processing (for example, histogram processing, peak detection processing, and the like) of constructing the distance image on the basis of the distance signal. An image (image data) obtained by performing the signal processing by the signal processing circuit 405 is supplied to the monitor 406 and also supplied to the memory 407.

The monitor 406 displays the distance image captured by the solid-state imaging device 403 on the basis of the image data supplied from the signal processing circuit 405. As the monitor 406, for example, a panel type display device such as a liquid crystal panel or an organic EL panel is used.

The memory 407 stores the image data supplied from the signal processing circuit 405, that is, the image data of the distance image captured by the solid-state imaging device 403. The memory 407 corresponds to the storage device 100 according to the above embodiment.

Also in the distance measuring device 400 configured in this manner, the write time can be shortened by using the above-described storage device 100 as the memory 407.

### <7-3. Game Apparatus>

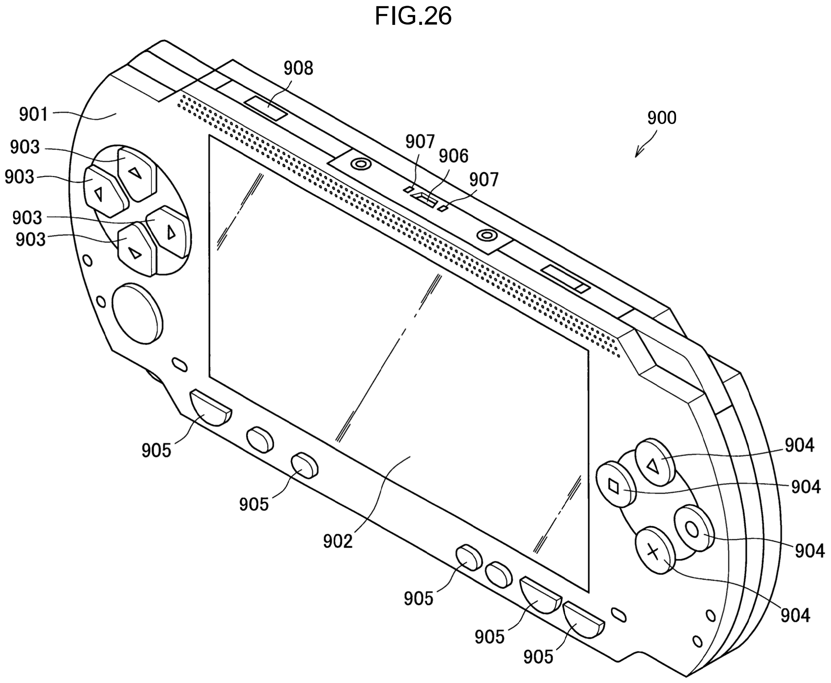

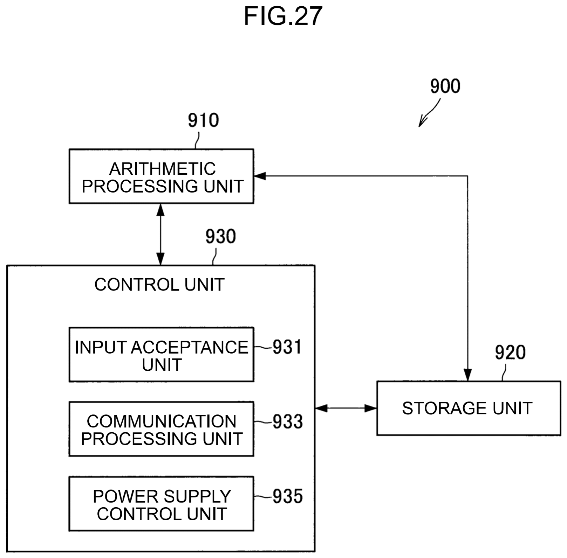

The game apparatus 900 to which the storage device 100 according to the above embodiment is applied will be described with reference to FIGS. 26 and 27. FIG. 26 is a diagram illustrating an example of an appearance of a game apparatus. FIG. 27 is a diagram illustrating an example of the schematic configuration of the game apparatus 900. The game apparatus 900 is an example of the electronic apparatus to which the storage device 100 according to the present embodiment is applied.

As illustrated in FIG. 26, for example, the game apparatus 900 has an appearance in which each component is disposed inside and outside an outer casing 901 formed in a horizontally long flat shape.

On the front surface of the outer casing 901, a display panel 902 is provided at the center thereof in the longitudinal direction. Further, operation keys 903 and operation keys 904 are provided on the left and right sides of the display panel 902, respectively, spaced apart from each other in the circumferential direction. An operation key 905 is provided at a lower end of the front surface of the outer casing 901. The operation keys 903, 904, and 905 function as direction keys, determination keys, or the like, and are used for selection of menu items displayed on the display panel 902, progress of a game, or the like.

On the upper surface of the outer casing 901, a connection terminal 906 for connecting an external device, a power supply terminal 907, a light receiving window 908 for performing infrared communication with the external device, and the like are provided.

As illustrated in FIG. 27, the game apparatus 900 includes an arithmetic processing unit 910 including a central processing unit (CPU), a storage unit 920 that stores various types of information, and a controller 930 that controls each configuration of the game apparatus 900. Power is supplied to the arithmetic processing unit 910 and the controller 930 from, for example, a battery (not illustrated) or the like.

The arithmetic processing unit 910 generates a menu screen for allowing a user to set various types of information or select an application. In addition, the arithmetic processing unit 910 executes the application selected by the user.

The storage unit 920 stores various types of information set by the user. The storage unit 920 corresponds to the storage device 100 according to the above embodiment.

The controller 930 includes an input receiving unit 931, a communication processing unit 933, and a power controller 935. The input receiving unit 931 detects, for example, the states of the operation keys 903, 904, and 905. Furthermore, the communication processing unit 933 performs communication processing with an external device. The power controller 935 controls power supplied to each unit of the game apparatus 900.

Also in the game apparatus 900 configured in this manner, the write time can be shortened by using the above-described storage device 100 as the storage unit 920.

It is noted that the storage device 100 according to each of the above-described embodiments may be mounted on the same semiconductor chip together with a semiconductor circuit forming an arithmetic device or the like to form a semiconductor device (System-on-a-Chip: SoC).

Furthermore, the storage device 100 according to the above embodiment can be mounted on various electronic devices on which a memory (storage unit) can be mounted as described above. For example, the storage device 100 may be mounted on various electronic devices such as a notebook personal computer (PC), a mobile device (for example, a smartphone, a tablet PC, or the like), a personal digital assistant (PDA), a wearable device, and a music device in addition to the imaging device 300 and the game apparatus 900. For example, the storage device 100 is used as various memories such as a storage.

### <8. Appendix>

Note that the present technology can also have the following configurations.
(1) A storage device comprising:
   a magnetoresistive element whose magnetization direction is variable between a first state and a second state;
   a selection element connected to the magnetoresistive element; and
   a write unit that switches and supplies, to the magnetoresistive element, a first current for bringing the magnetization direction of the magnetoresistive element into the first state and a second current for bringing the magnetization direction of the magnetoresistive element into the second state.
(2) The storage device according to (1), wherein
   the first current is larger than the second current.
(3) The storage device according to (1) or (2), wherein
   the write unit supplies a constant current to the magnetoresistive element as one or both of the first current and the second current.
(4) The storage device according to (3), wherein
   the write unit includes a constant current generation circuit that generates the constant current.
(5) The storage device according to (4), wherein
   the constant current generation circuit includes
   a first voltage generation circuit that is connected to the magnetoresistive element and generates a first voltage, and
   a second voltage generation circuit that is connected to the selection element and generates a second voltage.
(6) The storage device according to (5), wherein
   the first voltage generation circuit outputs, as the first voltage, a voltage selected from a plurality of voltages having different magnitudes.
(7) The storage device according to (5) or (6), wherein
   the second voltage generation circuit changes a voltage with a variable resistor and outputs the voltage as the second voltage.
(8) The storage device according to any one of (5) to (7), wherein
   the selection element has a drain terminal, a source terminal, and a gate terminal,
   one terminal of two terminals of the magnetoresistive element is connected to a bit line, the other terminal is connected to the drain terminal or the source terminal,
   the gate terminal is connected to a word line,
   the first voltage generation circuit is connected to the bit line and the second voltage generation circuit, and
   the second voltage generation circuit is connected to the word line.
(9) The storage device according to any one of (1) to (8), wherein
   the write unit supplies a pulse current to the magnetoresistive element as one or both of the first current and the second current.
(10) The storage device according to (9), wherein
   the write unit repeats the supply of the pulse current to the magnetoresistive element one or more times.
(11) The storage device according to (10), wherein
   the write unit reads a state of the magnetization direction of the magnetoresistive element after the supply of the pulse current, and repeats the supply of the pulse current to the magnetoresistive element one or more times when the read state is not a desired state.
(12) The storage device according to (10) or (11), wherein
   a pulse width of the pulse current is different for each supply of the pulse current.
(13) The storage device according to any one of (9) to (12), wherein
   a pulse width of the pulse current is 0.1 ns or more and 20 ns or less.
(14) The storage device according to any one of (1) to (13), wherein
   the write unit changes the first current to a third current smaller than the first current in a middle of writing to bring the magnetoresistive element into the first state.
(15) The storage device according to any one of (1) to (13), wherein
   the write unit changes the second current to a fourth current smaller than the second current in a middle of writing to bring the magnetoresistive element into the second state.
(16) The storage device according to any one of (1) to (13), wherein
   the write unit
   changes the first current to a third current smaller than the first current in a middle of writing to bring the magnetoresistive element into the first state, and
   changes the second current to a fourth current smaller than the second current in a middle of writing to bring the magnetoresistive element into the second state.
(17) The storage device according to any one of (1) to (16), wherein
   the magnetoresistive element is an element in which the magnetization direction varies by using a voltage controlled magnetic anisotropy (VCMA) effect.
(18) An electronic apparatus comprising
   a storage device that stores data, wherein
   the storage device includes
   a magnetoresistive element whose magnetization direction is variable between a first state and a second state,
   a selection element connected to the magnetoresistive element, and
   a write unit that switches and supplies, to the magnetoresistive element, a first current for bringing the magnetization direction of the magnetoresistive element into the first state and a second current for bringing the magnetization direction of the magnetoresistive element into the second state.
(19) A storage device control method comprising
   switching and supplying, to a magnetoresistive element whose magnetization direction is variable between a first state and a second state, a first current for bringing the magnetization direction of the magnetoresistive element into the first state and a second current for bringing the magnetization direction of the magnetoresistive element into the second state.
(20) An electronic apparatus including the storage device according to any one of (1) to (17).
(21) A storage device control method for controlling the storage device according to any one of (1) to (17).

### Reference Signs List

- 1: MEMORY CELL ARRAY

- 10: MEMORY CELL
- 11: MAGNETORESISTIVE ELEMENT
- 12: SELECTION ELEMENT
- 20: PERIPHERAL CIRCUIT
- 21: I/O
- 22: CONTROL CIRCUIT
- 23: VOLTAGE GENERATION CIRCUIT
- 24: WRITE CIRCUIT
- 25: READ CIRCUIT
- 26: BIT LINE ADDRESS DECODER
- 27: BIT LINE CONTROL CIRCUIT
- 28: WORD LINE ADDRESS DECODER
- 29: WORD LINE CONTROL CIRCUIT
- 30: SENSE AMPLIFIER
- 100: STORAGE DEVICE
- 111: FIXED LAYER
- 112: TUNNEL BARRIER LAYER
- 113: RECORDING LAYER
- 114: MAGNETIC FIELD GENERATION LAYER
- 241: CONSTANT CURRENT GENERATION CIRCUIT
- 241a: FIRST VOLTAGE GENERATION CIRCUIT
- 241b: SECOND VOLTAGE GENERATION CIRCUIT
- 300: IMAGING DEVICE
- 307: MEMORY
- 400: DISTANCE MEASURING DEVICE
- 407: MEMORY
- 900: GAME APPARATUS
- 920: STORAGE UNIT
- A1: AMPLIFIER
- BL: BIT LINE
- R1: RESISTOR
- R2: RESISTOR
- R3: RESISTOR
- R4: RESISTOR
- R5: VARIABLE RESISTOR
- SL: SOURCE LINE
- SW1: SWITCH
- SW2: SWITCH
- SW3: SWITCH
- SW4: SWITCH
- T1: TRANSISTOR
- WL: WORD LINE

## Claims

1. A storage device comprising:
a magnetoresistive element whose magnetization direction is variable between a first state and a second state;
a selection element connected to the magnetoresistive element; and
a write unit that switches and supplies, to the magnetoresistive element, a first current for bringing the magnetization direction of the magnetoresistive element into the first state and a second current for bringing the magnetization direction of the magnetoresistive element into the second state.

2. The storage device according to claim 1, wherein
the first current is larger than the second current.

3. The storage device according to claim 1, wherein
the write unit supplies a constant current to the magnetoresistive element as one or both of the first current and the second current.

4. The storage device according to claim 3, wherein
the write unit includes a constant current generation circuit that generates the constant current.

5. The storage device according to claim 4, wherein
the constant current generation circuit includes
a first voltage generation circuit that is connected to the magnetoresistive element and generates a first voltage, and
a second voltage generation circuit that is connected to the selection element and generates a second voltage.

6. The storage device according to claim 5, wherein
the first voltage generation circuit outputs, as the first voltage, a voltage selected from a plurality of voltages having different magnitudes.

7. The storage device according to claim 5, wherein
the second voltage generation circuit changes a voltage with a variable resistor and outputs the voltage as the second voltage.

8. The storage device according to claim 5, wherein
the selection element has a drain terminal, a source terminal, and a gate terminal,
one terminal of two terminals of the magnetoresistive element is connected to a bit line, the other terminal is connected to the drain terminal or the source terminal,
the gate terminal is connected to a word line,
the first voltage generation circuit is connected to the bit line and the second voltage generation circuit, and
the second voltage generation circuit is connected to the word line.

9. The storage device according to claim 1, wherein
the write unit supplies a pulse current to the magnetoresistive element as one or both of the first current and the second current.

10. The storage device according to claim 9, wherein
the write unit repeats the supply of the pulse current to the magnetoresistive element one or more times.

11. The storage device according to claim 10, wherein
the write unit reads a state of the magnetization direction of the magnetoresistive element after the supply of the pulse current, and repeats the supply of the pulse current to the magnetoresistive element one or more times when the read state is not a desired state.

12. The storage device according to claim 10, wherein
a pulse width of the pulse current is different for each supply of the pulse current.

13. The storage device according to claim 10, wherein
a pulse width of the pulse current is 0.1 ns or more and 20 ns or less.

14. The storage device according to claim 1, wherein
the write unit changes the first current to a third current smaller than the first current in a middle of writing to bring the magnetoresistive element into the first state.

15. The storage device according to claim 1, wherein
the write unit changes the second current to a fourth current smaller than the second current in a middle of writing to bring the magnetoresistive element into the second state.

16. The storage device according to claim 1, wherein
the write unit
changes the first current to a third current smaller than the first current in a middle of writing to bring the magnetoresistive element into the first state, and
changes the second current to a fourth current smaller than the second current in a middle of writing to bring the magnetoresistive element into the second state.

17. The storage device according to claim 1, wherein
the magnetoresistive element is an element in which the magnetization direction varies by using a voltage controlled magnetic anisotropy (VCMA) effect.

18. An electronic apparatus comprising
a storage device that stores data, wherein
the storage device includes
a magnetoresistive element whose magnetization direction is variable between a first state and a second state,
a selection element connected to the magnetoresistive element, and
a write unit that switches and supplies, to the magnetoresistive element, a first current for bringing the magnetization direction of the magnetoresistive element into the first state and a second current for bringing the magnetization direction of the magnetoresistive element into the second state.

19. A storage device control method comprising
switching and supplying, to a magnetoresistive element whose magnetization direction is variable between a first state and a second state, a first current for bringing the magnetization direction of the magnetoresistive element into the first state and a second current for bringing the magnetization direction of the magnetoresistive element into the second state.
